Europäisches Patentamt

European Patent Office

Office européen des brevets

(19)

(11) **EP 0 884 734 B1**

(12) # EUROPEAN PATENT SPECIFICATION

(45) Date of publication and mention
of the grant of the patent:
**13.03.2002 Bulletin 2002/11**

(51) Int Cl.$^7$: **G11C 29/00**

(21) Application number: **98114709.3**

(22) Date of filing: **29.12.1992**

(54) **Nonvolatile semiconductor memory**

Nichtflüchtiger Halbleiterspeicher

Mémoire morte à semiconducteur

(84) Designated Contracting States:
**DE FR GB IT**

(30) Priority: **28.05.1992 JP 13708092**

(43) Date of publication of application:
**16.12.1998 Bulletin 1998/51**

(62) Document number(s) of the earlier application(s) in
accordance with Art. 76 EPC:
**92311829.3 / 0 549 374**

(73) Proprietor: **FUJITSU LIMITED**
**Kawasaki-shi, Kanagawa 211-8588 (JP)**

(72) Inventor: **Yoshida, Masanobu Fujitsu Limited**
**Kanagawa, 211-8588 (JP)**

(74) Representative: **Hitching, Peter Matthew et al**
**Haseltine Lake & Co.,**
**Imperial House,**
**15-19 Kingsway**
**London WC2B 6UD (GB)**

(56) References cited:
**DE-A- 3 134 995        US-A- 4 498 151**

## Description

This invention relates to a nonvolatile semiconductor memory, particularly to an EPROM and an EEPROM including a nonvolatile memory circuit and, more particularly to a circuit construction of a nonvolatile semiconductor memory of the batch erasure type (hereinafter referred to as a flash memory). In particular the present invention seeks an improvement in the reliability of a writing operation in a nonvolatile semiconductor memory.

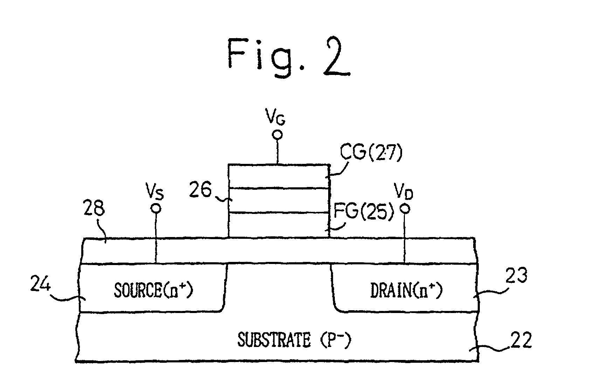

Fig. 2 of the accompanying drawings shows diagrammatically a structure of a cell used in a flash memory.

In this figure, indicated at $V_G$ is a gate terminal, at $V_D$ a drain terminal, at $V_S$ a source terminal, at 27 a control gate CG connected to the gate terminal $V_G$, and at 25 a floating gate FG which is controlled by the potential of the control gate CG.

Further, indicated at 22 is a semiconductor substrate, e.g. a semiconductor substrate having P-type conductivity. On the semiconductor substrate 22 are mounted well portions 23, 24 made of semiconductor having N-type conductivity. The well portion 23 forms a drain while the well portion 24 forms a source. Indicated at 26, 28 are insulating films.

When data is read from the cell, 0V is applied to the source terminal $V_S$, a read voltage (normal supply voltage $V_{CC}$) of 5V is applied to the gate terminal $V_G$, and a voltage of about 1V is applied to the drain terminal $V_D$. Then, it is discriminated whether the read data is "1" or "0" depending upon whether a current flows through the cell. On the other hand, when data is written in the cell, 0V is applied to the source terminal $V_S$, a write/erase voltage $V_{PP}$ of about 12V is applied to the gate terminal $V_G$, and a write drain voltage $V_W$ (lower than $V_{PP}$) is applied to the drain terminal $V_D$. Thereby, electrons are injected into the floating gate FG from a drain region (writing operation). Further, when the data is erased, the drain terminal $V_D$ is brought into an open state, and 0V and the write/erase voltage $V_{PP}$ are applied to the gate terminal $V_G$ and the source terminal $V_S$ respectively. Thereby, the electrons are taken from the floating gate FG to a source region (erasing operation).

When the data is written, it is required to check whether the data is written sufficiently in the memory cell (write verification). Likewise, when the data is erased, it is required to check whether the data is erased sufficiently from the memory cell (erase verification).

The write verification and erase verification are carried out so as to confirm whether the degree of writing and the degree of erasing have a sufficient margin for the read voltage, i.e., a variation range of the normal supply voltage $V_{CC}$ (5V ± 0.5V). Generally, these verifications are carried out to confirm that an operation margin of about 0.5V to 1.0V is available for a voltage range of $V_{CC}$. In this case, the verify voltage including the operation margin is 6V to 6.5V in the write verification, and 3.5V to 4V in the erase verification.

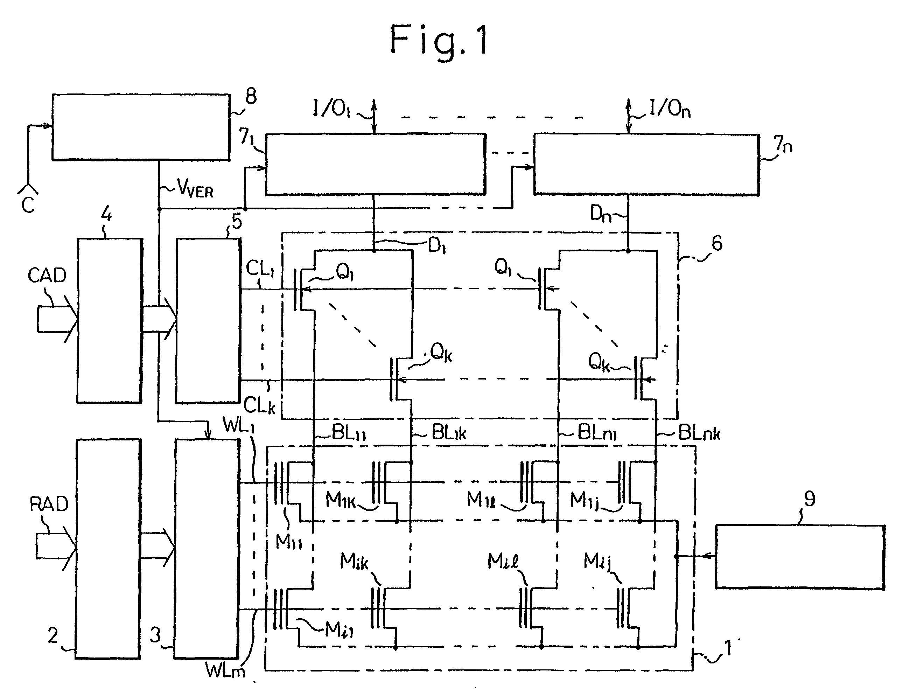

It is expected that the write verification and the erase verification can be accomplished easily if the verify voltage including the operation margin to be secured is applied to word lines (for example, word lines $WL_1$ to $WL_m$ of the flash memory shown in Fig. 1), so that the sensitivity of the S/A circuit is the same regardless of whether the voltage $V_{CC}$ or the verify voltage is applied as the supply voltage of the S/A circuit.

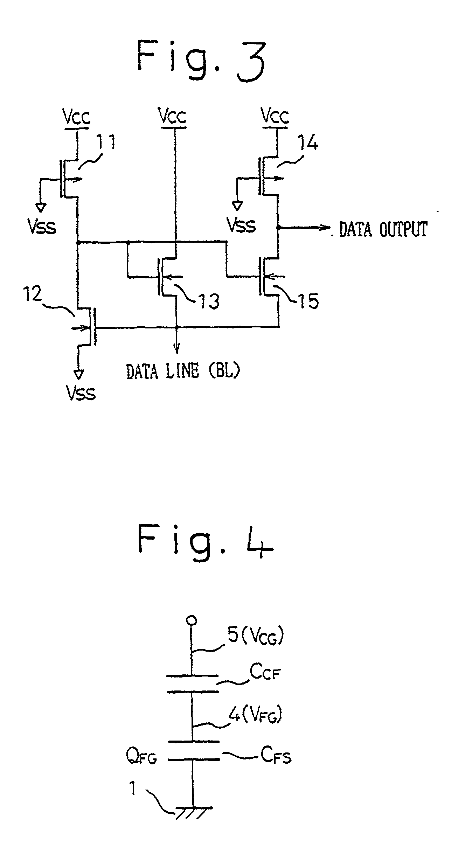

Fig. 3 of the accompanying drawings shows a construction of a general S/A circuit used in the nonvolatile semiconductor memory such as an EPROM.

In this figure, indicated at $V_{CC}$ is a line of a supply voltage 5V, and at $V_{SS}$ a line of a supply voltage 0V. Between the power supply lines $V_{CC}$ and $V_{SS}$ are connected a p-channel transistor 11 and an n-channel transistor 12 in series. A gate of the transistor 11 is connected to power supply line $V_{SS}$, while a gate of the transistor 12 is connected to a data line (i.e., a bit line). Between the power supply line $V_{CC}$ and the data line is connected an n-channel transistor 13 whose gate is connected to drains of the respective transistors 11, 12. Likewise, between the power supply line $V_{CC}$ and the data line are connected a p-channel transistor 14 and an n-channel transistor 15 in series. A gate of the transistor 14 is connected to the power supply line $V_{SS}$, while a gate of the transistor 15 is connected to the drains of the respective transistors 11, 12. An output (data output) of the S/A circuit is taken from drains of the respective transistors 14, 15.

In this construction, when the data read from the memory cell is "1", i.e., when the level of the data line is "H", the transistor 12 is turned on and thereby a drain potential thereof is reduced to "L" level. Accordingly, the transistor 15 is cut off. Thus, the voltage of "H" level is output from the power supply line $V_{CC}$ through the transistor 14 (data output). In other words, the data having the same level as the read data is sensed. Conversely, when the data read from the memory cell is "0", the transistor 12 is cut off and the voltage of "H" level is fed from the power supply line $V_{CC}$ through the transistor 11 to the gate of the transistor 15 to turn the transistor 15 on. Thereupon, the level of a data output line is reduced to "L" (the data of "L" level is the same as the read data).

In this way, the transistor 15 is provided with a function of transmitting the level of the bit line to the data output line (bit line level adjustment), and the transistor 14 is provided with a function of discriminating the data of the memory cell according to the state (on/off) of the transistor 15.

Further, in the case where the writing operation is carried out in such a manner that a current within a dead band of the sense amplifier is caused to flow through the cell transistor in the conventional nonvolatile semiconductor memory, the sense amplifier oscillates during the reading operation and the data cannot be read accurately. However, such an inaccurate reading operation cannot always be detected in the write verification, thus the conventional nonvolatile semiconductor memory has lacked the reliability of the written data.

It is desirable to provide a nonvolatile semiconductor memory capable of verifying, when data is written in a cell transistor, whether a writing operation to the cell transistor is sufficient to the degree that a sense amplifier does not oscillate during a reading operation, and of carrying out the sufficient writing operation to the degree that the sense amplifier does not oscillate during the reading operation.

According to a first aspect of the present invention there is provided a nonvolatile semiconductor memory including: a matrix of nonvolatile erasable memory cell transistors formed at intersections between word lines and bit lines; a row decoder; a column decoder; sense amplifiers connected operatively to the said bit lines; and verify means operable to perform at least one type of verify operation, which verify operation may be a write verify operation, carried out on one of the memory cell transistors after that transistor has had information written therein in a write operation performed by write means of the memory, for determining whether or not the said information can be read out accurately from the transistor in a subsequent read operation, or which verify operation may be an erase verify operation, carried out on one of the memory cell transistors after that transistor has had any information written therein erased in an erase operation performed by erase means of the memory, for determining whether or not that information has been erased sufficiently that in a subsequent read operation the transistor is read as being in an erased condition; characterised in that the said verify means include: storage means operable, during a predetermined detection period commencing following the said write operation or the said erase operation, as the case may be, to store two or more output signals of that one of the said sense amplifiers which is connected to the said one memory cell transistor involved in the write or erase operation concerned, each said output signal representing a result of a comparison between a read signal derived from the transistor and a reference signal; decision means operable to detect when the result represented by any one of the stored output signals is not a predetermined desired result for the said write or erase operation concerned and, following such detection, to determine that the write or erase operation was not sufficient that in said subsequent read operation the correct information will be read out even when a power source voltage applied to the memory exhibits variation; and repeat means operable, when the determination by the said decision means is that the said write operation or erase operation was not sufficient, to cause that operation be repeated.

According to a second aspect of the present invention there is provided a nonvolatile semiconductor memory including: a matrix of nonvolatile erasable memory cell transistors formed at intersections between word lines and bit lines; a row decoder; a column decoder; sense amplifiers connected operatively to the said bit lines; and verify means operable to perform at least one type of verify operation, which verify operation may be a write verify operation, carried out on one of the memory cell transistors after that transistor has had information written therein in a write operation performed by write means of the memory, for determining whether or not the said information can be read out accurately from the transistor in a subsequent read operation, or which verify operation may be an erase verify operation, carried out on one of the memory cell transistors after that transistor has had any information written therein erased in an erase operation performed by erase means of the memory, for determining whether or not that information has been erased sufficiently that in a subsequent read operation the transistor is read as being in an erased condition; characterised in that the said verify means include: decision means operable, during a predetermined detection period commencing following the said write operation or the said erase operation, as the case may be, to detect a preselected transition in an output signal of that one of the said sense amplifiers which is connected to the said one memory cell transistor involved in the write or erase operation concerned, the said output signal representing a result of a comparison between a read signal derived from the transistor and a reference signal, and, following such detection, to determine that the write or erase operation was not sufficient that in said subsequent read operation the correct information will be read out even when a power source voltage applied to the memory exhibits variation; and repeat means operable, when the determination by the said decision means is that the said write operation or erase operation was not sufficient, to cause that operation be repeated.

In one embodiment the nonvolatile semiconductor memory further comprises timing signal generation means for generating a timing signal defining the said predetermined detection period.

The decision means in one embodiment of the second aspect of the present invention comprise a flip-flop which is connected for receiving the sense-amplifier output signal continuously during the said predetermined detection period and which is switched from a first state to a second state in the event that said preselected transition in the sense-amplifier output signal occurs.

In one embodiment of the first aspect of the present invention the nonvolatile semiconductor memory further comprises timing signal generation means for generating a series of timing pulses over the course of the said predetermined detection period; the said storage means being operable in response to each timing pulse of the said series to store the sense-amplifier output signal at the time of the timing pulse concerned; and the said decision means being operable, after such sense-amplifier output signals have been stored in response to all of the pulses of the said series, to detect when the result represented by any one of the stored output signals is not said predetermined desired result.

The storage means in this embodiment may comprise a shift register having: a data input connected for receiving the said sense-amplifier output signal; a shift input connected for receiving the timing pulses of the said series; a plurality of storage portions, each for storing one of the said output signals; and a plurality of data outputs corresponding respectively to the said storage portions of the said plurality, each for outputting the stored output signal held in its corresponding storage portion; the said decision means being connected to the said data outputs for detecting when the result represented by the stored output signal at any one of the said data outputs is not the said predetermined desired result.

Reference will now be made, by way of example, to the accompanying drawings, in which:

Fig. 1 is an overall construction diagram showing a flash memory as an embodiment of the invention;
Fig. 2 is a diagram showing a cell structure for explaining an operation of the flash memory;
Fig. 3 is a circuit diagram showing a construction of the S/A circuit as an example of the prior art;
Fig. 4 is a diagram showing a relationship between a capacitance between a control gate and a floating gate and a capacitance between the floating gate and a substrate in a cell transistor;
Fig. 5 is a diagram showing an exemplary relationship between the number of writing operations executed on a cell transistor having a bad writing characteristic and a current flowing through this cell transistor;
Fig. 6 is a circuit diagram showing parts of a first embodiment of the present invention;
Figs. 7 - 9 are waveform charts for explaining an operation of the embodiment shown in Fig. 6;
Figs. 10 to 13 are block diagrams for explaining the operation of the embodiment shown in Fig. 6;
Fig. 14 is a circuit diagram showing parts of a second embodiment of the present invention;
Figs. 15 to 17 are waveform charts for explaining an operation of the embodiment shown in Fig. 14;
Figs. 18 to 21 are block diagrams for explaining the operation of the embodiment shown in Fig. 14;
Figs. 22(A) and 22(B) are flow charts showing an operation procedure in an embodiment of the present invention;
Figs. 23(A) and 23(B) are diagrams showing an example of a timing signal generating circuit used in an embodiment of the present invention.

Fig. 1 shows parts of an overall construction of a flash type memory as a specific example of a nonvolatile semiconductor memory embodying the present invention.

In this figure, indicated at 1 is a cell array formed by arranging erasable nonvolatile memory cells $M_{i,j}$ at intersections of a plurality of word lines $WL_1$ to $WL_m$ and a plurality of bit lines $BL_{11}$ to $BL_{1k}$, ..., $BL_{n1}$ to $BL_{nk}$. In this embodiment, the cell array is divided into n blocks, in each of which (k × m) memory cells are arranged. Indicated at 2 is a row address buffer for buffering a row address RAD of an address signal fed externally thereto, at 3 a row decoder for decoding the row address and selecting any one of the word lines $WL_1$ to $WL_m$, at 4 a column address buffer for buffering a column address CAD of the address signal, and at 5 a column decoder for decoding the column address and selecting any one of column lines $CL_1$ to $CL_k$ corresponding to the bit lines $BLi_1$ to $BLi_k$ for each of the aforementioned blocks. Indicated at 6 is a column gate circuit including transfer gate transistors $Q_1$ to $Q_k$ corresponding to the bit lines $BL_{i1}$ to $BL_{ik}$ for each of the aforementioned blocks. The respective transistors $Q_1$ to $Q_k$ are turned on when the corresponding column lines $CL_1$ to $CL_k$ are selected, to thereby connect the selected bit line $BL_{ij}$ to a data line $D_i$.

Indicated at $7_1$ to $7_n$ are respectively writing circuits and S/A circuits for applying amplification to a write data and sense amplification to a read data between corresponding internal data lines $D_1$ to $D_n$ and external input/output data lines $I/O_1$ to $I/O_n$. Indicated at 8 is a verify source voltage generating circuit for generating a verify voltage $V_{VER}$ in accordance with a control signal C fed externally thereto. The generated verify source voltage $V_{VER}$ is supplied to the selected word lines $WL_1$ to $WL_m$ through the row decoder 3 as described later, and to the S/A circuit corresponding to the selected word line. Indicated at 9 is a source voltage supply circuit for supplying a source voltage in common to the respective sources of the nonvolatile memory cells $M_{ij}$.

Before describing preferred embodiments of the, present invention a problem associated with write verification and erase verification will be explained in detail with reference to Figs. 2 to 5.

A memory cell transistor used in a nonvolatile semiconductor memory according to an embodiment of the present invention may, for example, have a conventional construction as shown in Fig. 2.

When a high voltage of, e.g., 12.5V, is applied to a control gate 27 and a voltage of about 7V is applied to a drain 23, an avalanche breakdown phenomenon occurs near the drain 23. Thereby, a greater number of high energy electrons are generated, and some of the electrons are injected into a floating gate 25 to charge the gate 25 negative. This operation is referred to as a "writing operation" or "programming".

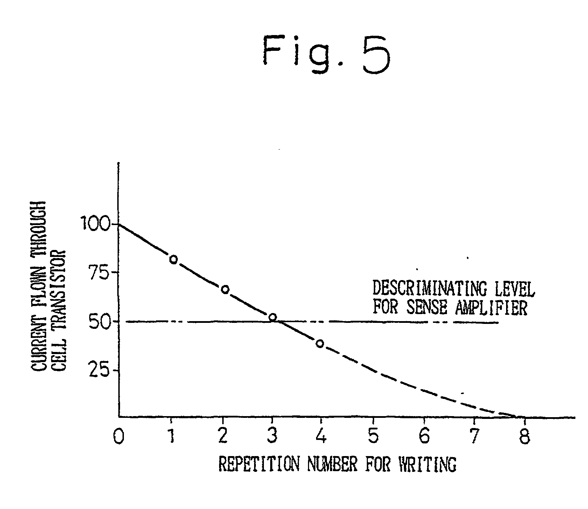

Incidentally, when it is assumed that a capacitance between the control gate 27 and the floating gate 25 is $C_{CF}$ and a capacitance between the floating gate 25 and a p-type silicon substrate 22 is $C_{FS}$, a relationship between these capacitances $C_{CF}$, $C_{FS}$ can be shown as in Fig. 4.

Further, when it is assumed that an amount of charge of the electrons injected into the floating gate 25 during the writing operation is $Q_{FG}$, a voltage of the control gate 27 is $V_{CG}$, and a voltage of the floating gate 25 is $V_{FG}$, the voltage $V_{FG}$ of the floating gate 25 can be obtained using the following equation (1).

$$V_{FG} = \frac{C_{CF} \times V_{CG}}{C_{FS} + C_{CF}} + \frac{Q_{FG}}{C_{FS} + C_{CF}} \qquad (1)$$

After the writing operation, the charge amount $Q_{FG}$ becomes a negative value and $Q_{FG}/(C_{FS} + C_{CF})$ is about -5V. On the other hand, $C_{CF}/(C_{FS} + C_{CF})$ is designed to have a value of about 0.6.

As a result, even if the voltage of 5V is applied to the control gate 27, the floating gate 25 maintains the negative potential and the cell transistor is not brought into an on-state, thereby allowing no current to flow therethrough. This state is assumed as a state where an information "0" is stored.

When ultraviolet rays are projected on this cell transistor, the electrons injected in the floating gate 25 are released to a substrate 22, and the charge amount $Q_{FG}$ of the injected electrons becomes zero. This operation is referred to as an "erasing operation". In this case, with $Q_{FG} = 0$, the voltage $V_{FG}$ of the floating gate 25 can be obtained using the following equation (2).

$$V_{FG} = \frac{C_{CF} \times V_{CG}}{C_{CF} + C_{CF}} \qquad (2)$$

In the equation (2), since $C_{CF}/(C_{FS} + C_{CF})$ is designed to have a value of about 0.6 as described above, the voltage $V_{FG}$ of the floating gate 25 becomes about 3V if the voltage of 5V is, for example, applied to the control gate 27 after the erasing operation.

Accordingly, the cell transistor is brought to the on-state in this case, thereby allowing a current of, e.g., 100μA to flow therethrough. This state is assumed as a state where an information "1" is stored.

Incidentally, in the EPROM, the data is output after the sense amplifier detects the current flowing through the cell transistor during the write verification or reading operation. Specifically, the sense amplifier is provided with a discriminating level of, e.g., 50μA, and is so designed as to output "H" (high level) when a current no lower than 50μA is flowing through the cell transistor (on the assumption that in this case the cell is in an erased state) and to output "L" (low level) when a current lower than 50μA is flowing through the cell transistor on the assumption that in this case a writing operation has been carried out.

Further, in the EPROM, the following method has been adopted so as to shorten a writing time. A pulse duration of a write signal (program signal) for instructing the writing operation can be shortened if the cell transistor has a good writing characteristic. In the case of a cell transistor having a poor writing characteristic, on the other hand, the write signal may need to be applied several times, i.e., the writing operation is repeated several times, and the charge amount $Q_{FG}$ of the floating gate 25 is increased little by little during each writing operation.

More specifically, the writing operation is carried out by the following procedure. (1) An address specified by a writing device is applied to an address terminal. (2) Write data is applied to a data terminal. (3) A write signal is applied to a control terminal. (4) The data is read and compared with the write data so as to verify the writing operation. (5) If it is confirmed, as a result of the verification, that the write data coincides with the read data, a write operation is performed at the next address, whereas the operations (1) to (4) are repeated again if these data are at variance with one another.

Fig. 5 shows an exemplary relationship between the number of writing operations executed on a cell transistor having such a poor writing characteristic and the current flowing through the cell transistor. In this example, the current flowing through the cell transistor which was initially 100μA, is changed to 80μA after the first writing operation, to 63μA after the second writing operation, to 51μA after the third writing operation, and to 38μA after the fourth writing operation.

In this case, the write data and the read data coincide with each other in the fourth writing operation, and the next address follows after the fourth writing operation. Therefore, a fifth writing operation is not executed on this cell transistor. In this case, no problem arises since the write voltage level is substantially below the discrimination level of the sense amplifier.

However, in this example, the current flowing through this cell transistor becomes 51μA after the third writing operation. This current value is very close to 50μA which is a discrimination level at which the sense amplifier discriminates whether the writing operation is carried out.

In actuality, the sense amplifier oscillates in such a case, thereby being incapable of outputting a normal output. In other words, the discrimination level has a range called a dead band. Accordingly, even if 50μA is regarded as the discrimination level, the sense amplifier cannot discriminate reliably, when the current is in a range (dead band) of, for example, 45μA to 55μA, and oscillates.

The cause of the above is generally said to be power supply noise. More specifically, suppose that when the supply voltage is at its normal level the cell transistor allows a current of 51μA to flow and the sense amplifier reads this as "H". If, however, the supply voltage is reduced at the time of reading so that the current flowing through the cell transistor is reduced to, for example, 49μA, then the sense amplifier outputs "L". After this the supply voltage may return to its original voltage value. Thereby, the current flowing through the cell transistor is returned to 51μA, and the sense amplifier outputs "H". In this way, the sense amplifier outputs "H" and "L" alternately repeatedly, i.e. is brought into an oscillating state.

In this case, a write verifying circuit in an EPROM writing apparatus for executing the writing operation to the EPROM, namely an EPROM writer, may detect "L" output of the sense amplifier despite the fact that the writing operation has not been carried out on a cell transistor to a sufficient extent that the sense amplifier does not oscillate, and may determine that an accurate writing operation has been executed on the cell transistor concerned on the basis that the write date and the read data coincide with each other.

As described above, in the conventional EPROM, when a writing operation that causes a current in the dead band of the sense amplifier to flow is executed on a cell transistor, the sense amplifier oscillates during the reading operation. Thus, the conventional EPROM has suffered the problem that it cannot detect when a data reading operation during the write verification produces an inaccurate result. This sort of problem has generally occurred in not only an EPROM, but also other nonvolatile semiconductor memories including an EEPROM and a flash type memory.

In view of the above problem, embodiments of the present invention seek to provide a nonvolatile semiconductor memory which, when the writing operation is executed on a cell transistor, is capable of verifying whether the writing operation on the cell transistor concerned has been carried out to a sufficient extent that the sense amplifier does not oscillate during the reading operation, and of executing the writing operation to the sufficient extent that the sense amplifier does not oscillate during the reading operation.

According to an embodiment of the present invention, after necessary information is written in the memory cell transistor, it is verified with the use of the sense amplifier whether the information is written accurately during the reading operation. If the information is still at an insufficient level, or if the output of the sense amplifier oscillates, the programming, or the writing operation, is repeated until it is determined that the information is written accurately during the reading operation.

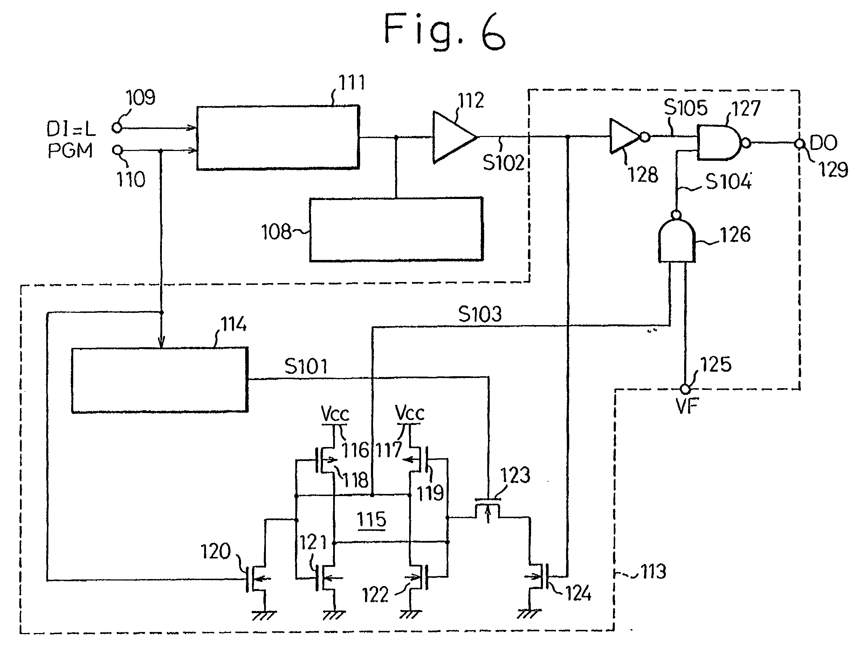

Hereafter, first and second embodiments of the present invention will be described with reference to Figs. 6 to 23, taking a case where the invention is applied to an EPROM as an example.

Fig. 6 is a circuit diagram showing a basic portion of the first embodiment.

In this figure, indicated at 108 is a memory cell array unit including arrayed cell transistors, at 109 a write data input terminal to which write data DI is input, and at 110 a write signal input terminal to which a write signal PGM is input.

Indicated at 111 is a writing circuit for writing the write data DI in the cell transistor in accordance with the write signal PGM, and at 112 a sense amplifier for reading the data stored in the cell transistor.

Indicated at 113 is a write verifying circuit (verifying means) for verifying whether information is written in the cell transistor to a sufficient extent that the sense amplifier 112 does not oscillate or to the extent that the information can be read accurately during a reading operation. In this write verifying circuit, indicated at 114 is a timing signal generating circuit for generating a timing signal S101 that becomes "H" during a specified period commencing a predetermined delay period after the writing operation, i.e. after the write signal PGM is inverted from "H" to "L".

Indicated at 115 is a flip-flop. In the flip-flop 115, indicated at 116, 117 are VCC power supply lines for supplying a supply voltage VCC, at 118, 119 p-MOS transistors (hereinafter referred to as p-MOS), and at 120 to 124 n-MOS transistors (hereinafter referred to as n-MOS).

Indicated at 125 is a verify signal input terminal to which a write verify signal (a so-called verify signal VF) is input, at 126, 127 NAND circuits, at 128 an inverter, and at 129 a data output terminal from which an output data DO is output.

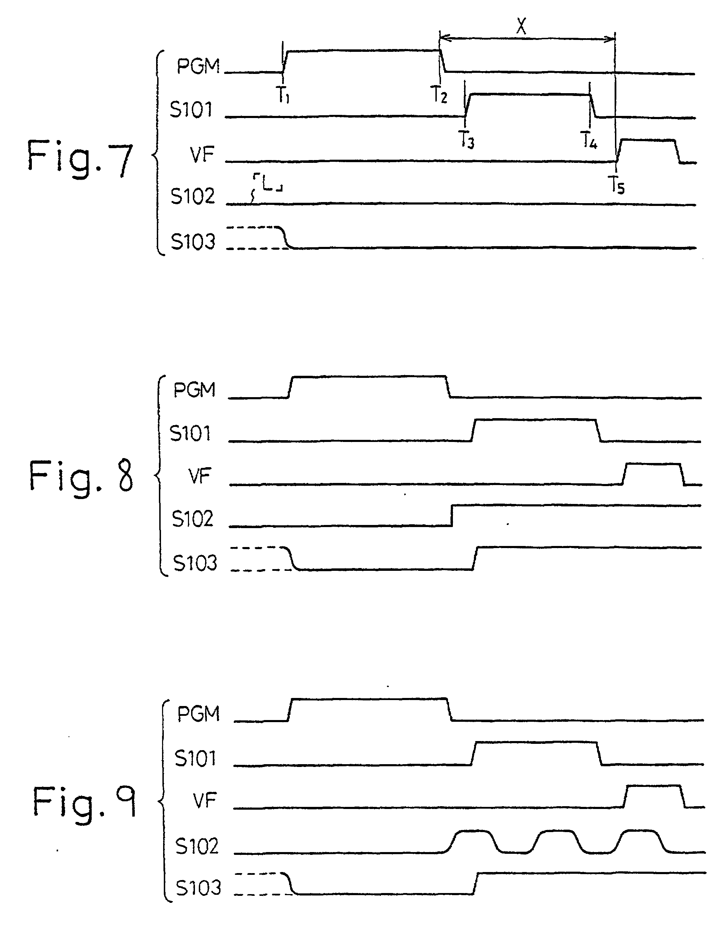

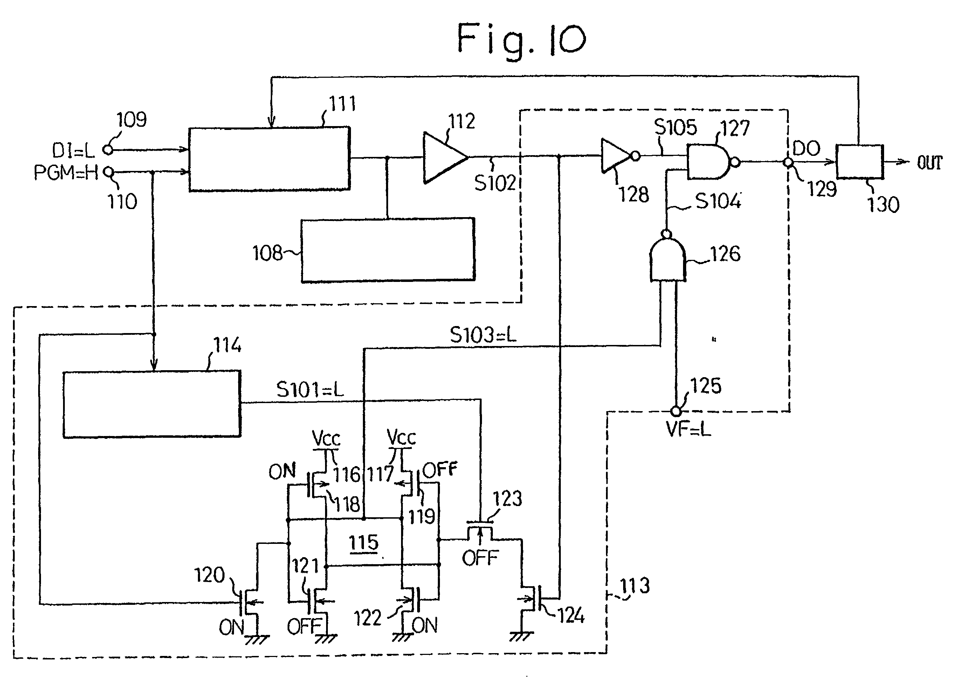

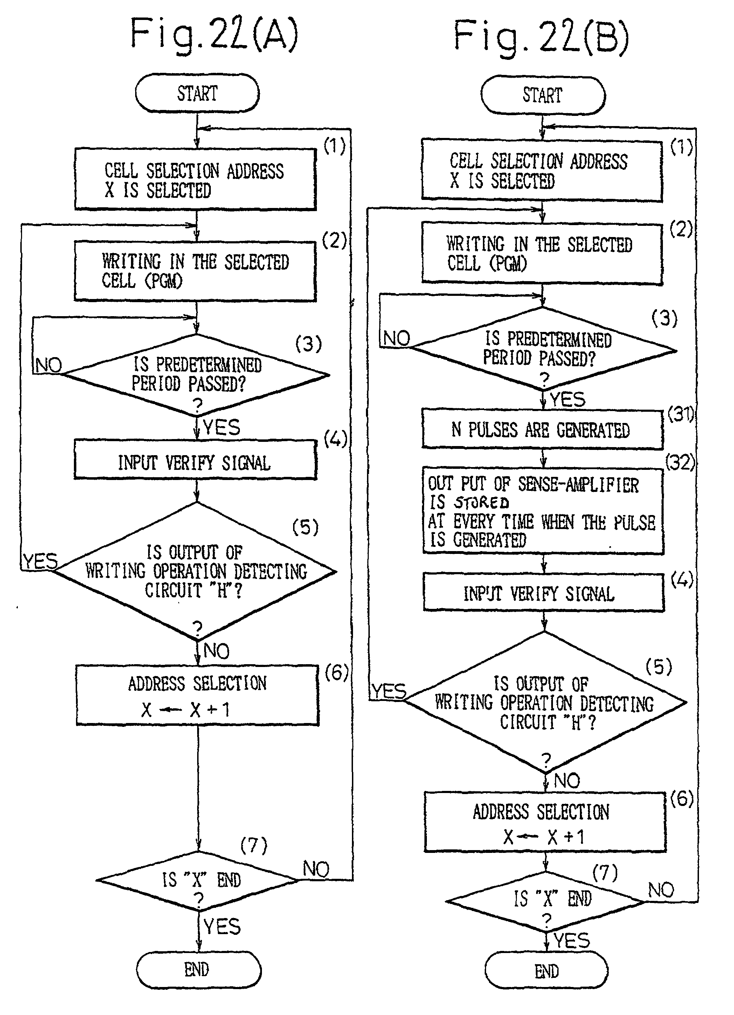

Figs. 7 to 9 are waveform charts for explaining an operation of this first embodiment, Figs. 10 to 13 are circuit diagrams for explaining the operation of the first embodiment, and Fig. 22(A)is a flow chart showing this operation. The operation of this embodiment will be explained sequentially step by step as shown in Fig. 22(A) hereunder.

In the first embodiment, a cell address X is selected in Step (1) when the verify signal becomes "L" as shown in Figs. 7 and 10 and in Step (2), when the write data becomes "L" (corresponding to the information "0") and the write signal PGM becomes "H", the information is written in the selected cell transistor; the n-MOS 120 is turned on; the p-MOS 118 is turned on; and the n-MOS 121 is turned off.

Further in this case, the timing signal generating circuit 114 outputs "L" as the timing signal S101 to thereby turn the n-MOS 123 off. However, since the p-MOS 118 is on and the n-MOS 121 is off, the p-MOS 119 is turned off and the n-MOS 122 is turned on, with the result that an output S103 of the flip-flop becomes "L".

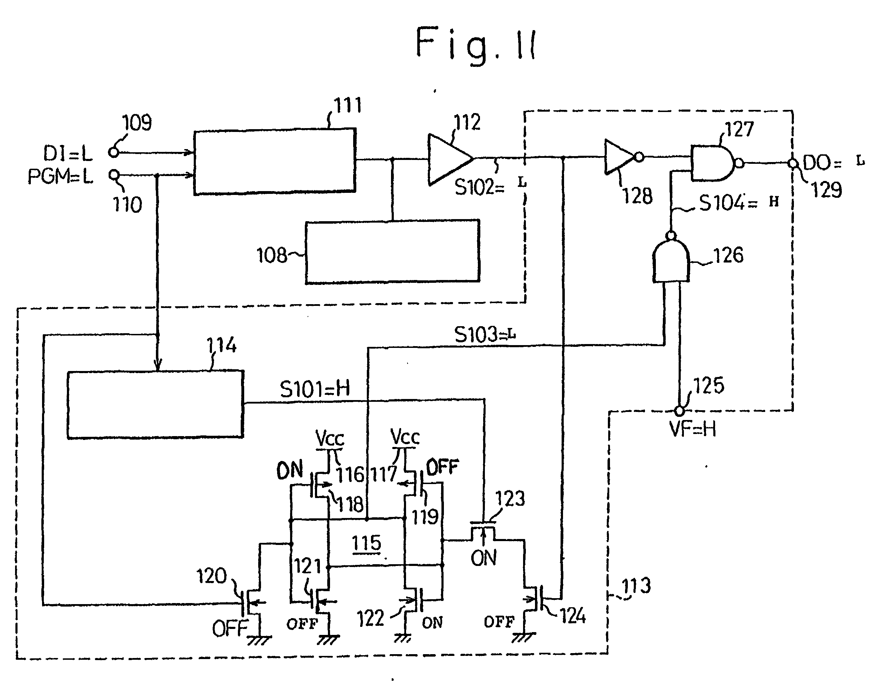

Thereafter, upon lapse of the specified period in Step (3), the write signal PGM becomes "L" and the first writing operation is completed as shown in Figs. 7 and 11. Thereupon, the n-MOS 120 is turned off, and the timing signal S101 becomes "H" and the n-MOS 123 is turned on.

Here, the n-MOS 124 is turned off in the case where the output S102 of the sense amplifier 112 becomes "L" stably after the writing operation to the cell transistor, i.e., the writing operation on the cell transistor is executed to a sufficient extent that the sense amplifier 112 does not oscillate.

As a result, since the p-MOS 118, p-MOS 119, n-MOS 121, n-MOS 122 are held in on-, off-, off-, and on-states respectively, the output S103 of the flip-flop 115 is held at "L".

When the verify signal VF becomes "H" in this state in Step (4), an output S104 of the NAND circuit 126 becomes "H" (Figure 11). In this case, since an output of the inverter 128 is "H", an output of the NAND circuit 127, namely the output data DO, becomes "L" which is fed to an EPROM writer (Step (5)).

In this case, the write data DI is "L" and the output data DO is "L", and the write data DI coincides with the output data DO. Accordingly, the EPROM writer stops writing the information in the cell transistor assuming that the writing operation to the cell transistor is sufficient, and this routine proceeds to Step (6) in which a next address X+1 is selected and the writing operation is executed for the next address X+1.

After repeating the above operation, it is discriminated whether the address X is a last address in Step (7). This routine ends if the discrimination result is in the affirmative while returning to Step (1) to repeat the above operation if the discrimination result is in the negative.

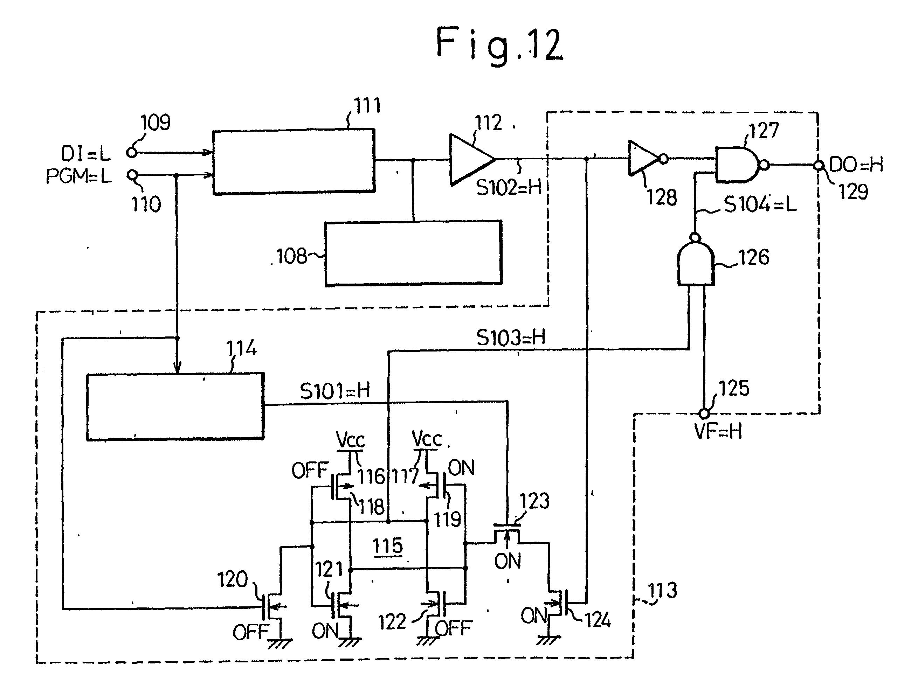

Contrary to this, the n-MOS 124 is turned on in the case where the output S102 of the sense amplifier 112 becomes "H" stably after the writing operation on the cell transistor,as shown in Figs. 8 and 12, i.e. the writing operation to the cell transistor was not sufficient.

In this case, since the n-MOS 120 is off and the n-MOS 123 is on, the p-MOS 119 is turned on; the n-MOS 122 is turned off; the p-MOS 118 is turned off; and the n-MOS 121 is turned on. As a result, the output S103 of the flip-flop 115 becomes "H".

When the verify signal VF becomes "H" in this state, the output S104 of the NAND circuit 126 becomes "L" and the output of the NAND circuit 127, namely the output data DO, becomes "H" which is fed to the EPROM writer (Step (5)).

In this case, the write data DI is "L" and the output data DO is "H", and the write data DI is at variance with the output data DO. Accordingly, the EPROM writer returns to Step (5) assuming that the writing operation to the cell transistor is insufficient, and causes a specified command signal to be returned from a desired writing operation designating circuit 130 (Figure 10) to the writing circuit 111 so as to cause the writing operation to be repeated on this cell transistor.

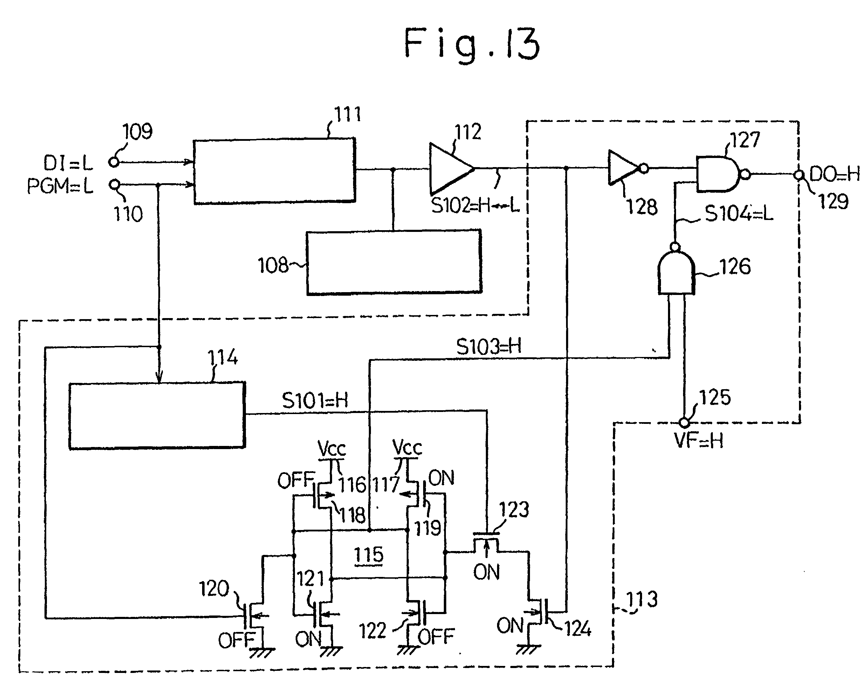

Further, in the case where the sense amplifier 112 oscillates, thereby bringing about oscillation of the output S102 thereof after the writing operation to the cell transistor as shown in Figs. 9 and 13, the n-MOS 124 is turned on when the output S102 of the sense amplifier 112 first becomes "H".

In this case, since the n-MOSs 120 and 123 are already off and on respectively, the p-MOS 119 is turned on and the n-MOS 122 is turned off, and the p-MOS 118 is turned off and the n-MOS 121 is turned on. As a result, the output S103 of the flip-flop 115 becomes "H".

When the verify signal VF becomes "H" in this state, the output S104 of the NAND circuit 126 becomes "L" and the output of the NAND circuit 127, namely the output data DO, becomes "H" which is fed to the EPROM writer.

In this case as well, the write data DI is "L" and the output data DO is "H", and the write data DI is at variance with the output data DO. Accordingly, the EPROM writer returns to Step (2) assuming that the writing operation to the cell transistor is insufficient in Step (5), and repeats the writing operation on this cell transistor.

In this way, in the first embodiment of the present invention, the write verifying circuit 113 outputs "L" having the same level as the write data as the output data DO only in the case where the sense amplifier 112 outputs "L" stably after the writing operation to the cell transistor, i.e. the writing operation to the cell transistor is sufficient to prevent the sense amplifier 112 from oscillating.

On the other hand, the write verifying circuit 113 outputs "H" having a level different from the write data DI as the output data DO in either the case where the sense amplifier 112 outputs "H" stably or in the case that the sense amplifier 112 oscillates after the writing operation to the cell transistor (because the writing operation to the cell transistor was not sufficient to prevent such oscillation of the sense amplifier 112).

In this way, according to the first embodiment, it can be verified through the built-in write verifying circuit 113 whether the writing operation to the cell transistor is sufficient to prevent the sense amplifier 112 from oscillating during the reading operation. Thus, when the information is written in the cell transistor, the writing operation can be executed to a sufficient extent that the sense amplifier 112 does not oscillate during the reading operation.

Referring to Fig. 5, in many cases the information is not written sufficiently even after the second writing operation, i.e. after the second programming operation. In the third programming operation shown in Figure 5, an output level is close to the discrimination level of the sense amplifier, and so the output of the sense amplifier may oscillate in many cases considering the influence of noise.

In this embodiment, the programming operation is repeated upon determination that the writing operation is insufficient in either of the two above cases (stable "H" output or oscillating output from the sense amplifier), thereby contributing to accuracy of the writing operation and improvement in the reliability of the read information.

Next will be described timings of the respective operations in this embodiment with reference to Fig. 7. The write command PGM for writing the specified information in one of the specified memory cell transistors is given at time T1, and is stopped at time T2. The writing operation is carried out during a period defined between T1 and T2. The timing signal S101 is output from the timing signal generating circuit 114 at time T3 following time T2, and is stopped at time T4. During a period defined between T3 and T4, the flip-flop 115 is actuated to latch a "H"-level output voltage of the sense amplifier.

Subsequently, at time T5, the verify signal VF is input, and thereupon the output state of the sense amplifier is discriminated according to the aforementioned method.

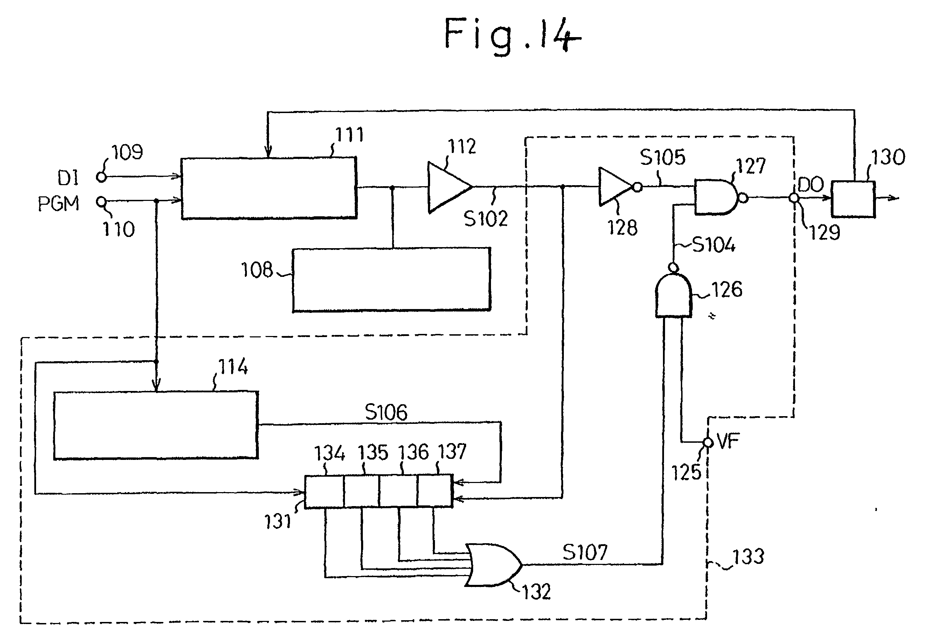

Fig. 14 is a circuit diagram showing a basic portion of the second embodiment according to the present invention. This second embodiment is provided with a write verify circuit 133 including a timing signal generating circuit 114, a four bit shift register 131, an OR circuit 132, NAND circuits 126, 127, and an inverter 128. The remaining construction of the second embodiment is similar to the first embodiment.

A flow chart shown in Fig. 22(B), relating to the second embodiment, is substantially similar to the one shown in Fig. 22(A).

The timing signal generating circuit 114 as shown in Fig. 14 generates a timing signal S106 that becomes "H" four times in a specified cycle until the verify signal becomes "H" after the writing operation on the cell transistor.

The shift register 131 is reset (i.e. the stored contents of the respective bits 134 to 137 become "L") when a write signal PGM is "H". The shift register 131 also reads an output S102 of a sense amplifier 112 and stores the level of the output when the timing signal S106 is "H".

The OR circuit 132 takes an OR logic of the contents stored in the respective bits 134 to 137 of the shift register 131, and feeds the result to the NAND circuit 126.

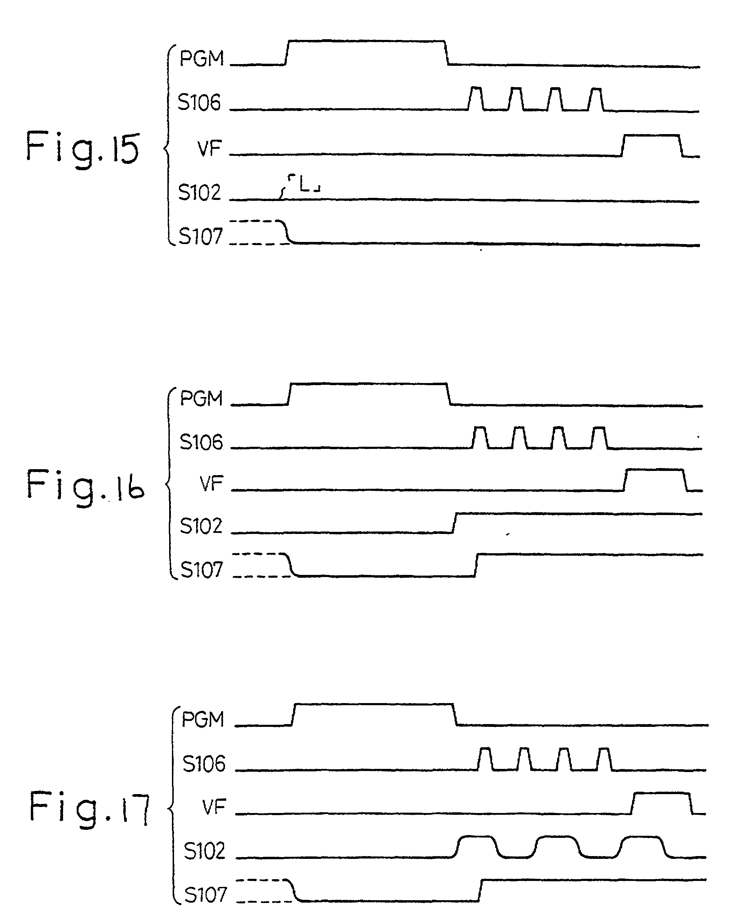

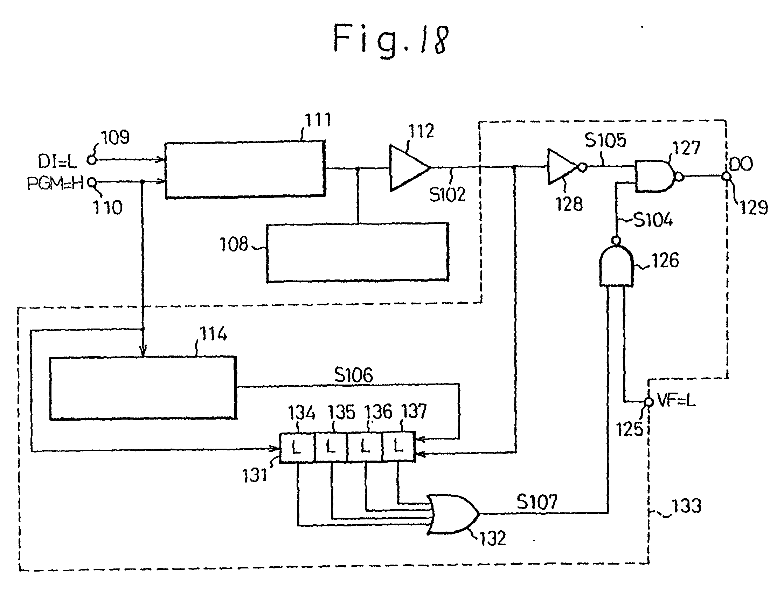

Figs. 15 to 17 are waveform charts for explaining an operation of this second embodiment, and Figs. 18 to 21 are circuit diagrams for explaining the operation of the second embodiment. In the second embodiment as shown in Figs. 15 and 18, when a write data DI is "L" and the write signal PGM becomes "H" in the state where the verify signal VF is "L", the writing operation on the cell transistor is carried out and the shift register 131 is reset.

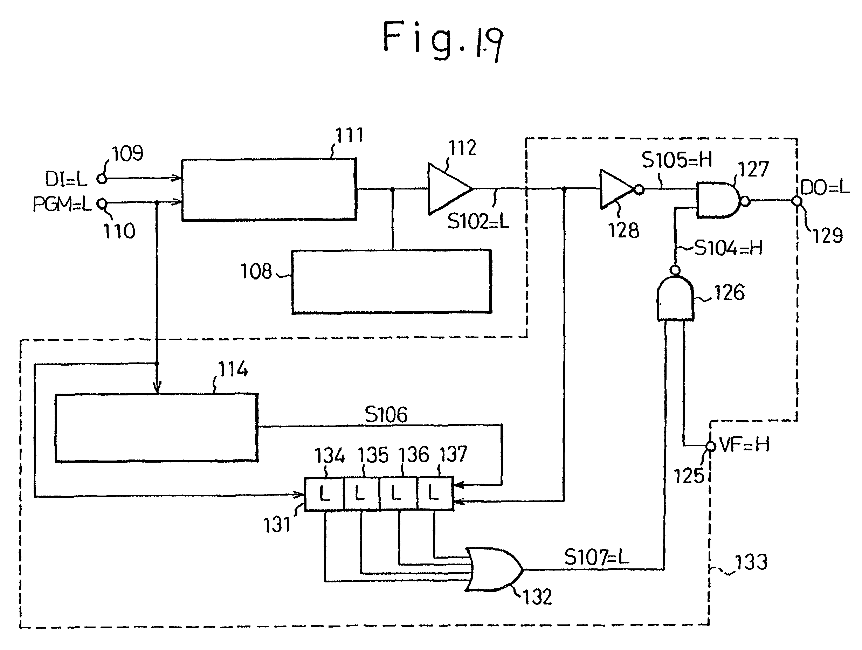

Thereafter, as shown in Figs. 15 and 19, when the write signal PGM becomes "L" and the first writing operation is completed, the timing signal S106 becomes "H" in the specified cycle, and the output S102 of the sense amplifier 112 is read by the shift register 131 in synchronism with the timing signal S106 (Steps (1) to (3) of Fig. 22(B)).

After the writing operation to the cell transistor four pulses are generated in Step (31) as shown in Fig. 22(B). In Step (32), at each such pulse, the output of the sense amplifier 112 is stored in the shift register (memory means).

In the case where the output S102 of the sense amplifier 112 is "L" stably, i.e. the writing operation to the cell transistor is sufficient to prevent the sense amplifier 112 from oscillating, the level read by the shift register 131 at each pulse in the timing signal S106 is always "L". Thereupon, the stored contents of the respective bits 134, 135, 136, 137 of the shift register 131 become "L", "L", "L", "L", and an output S107 of the OR circuit 132 remains "L".

When the verify signal VF becomes "H" in this state in Step (4), an output S104 of the NAND circuit 126 becomes "H". In this case, since an output of the inverter 128 is "H", an output of the NAND circuit 127, namely the output data DO, becomes "L" (Step (5)) which is fed to an EPROM writer.

In this case, the write data DI is "L" and the output data DO is "L", and the write data DI coincides with the output data DO. Accordingly, the EPROM writer stops writing the information in the cell transistor assuming that the writing operation to the cell transistor is sufficient, and proceeds to the writing operation to a next address (Steps (6) to (7)).

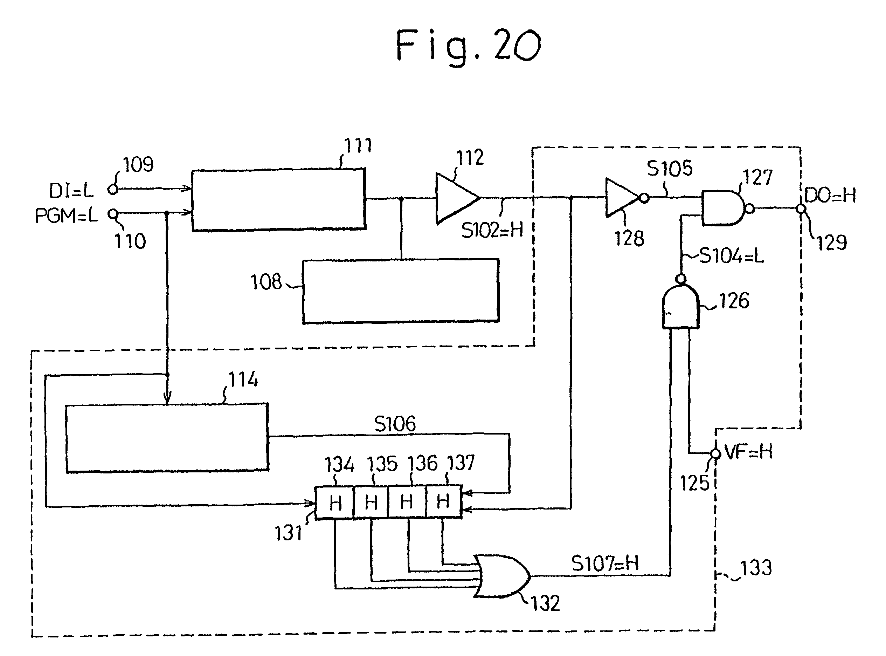

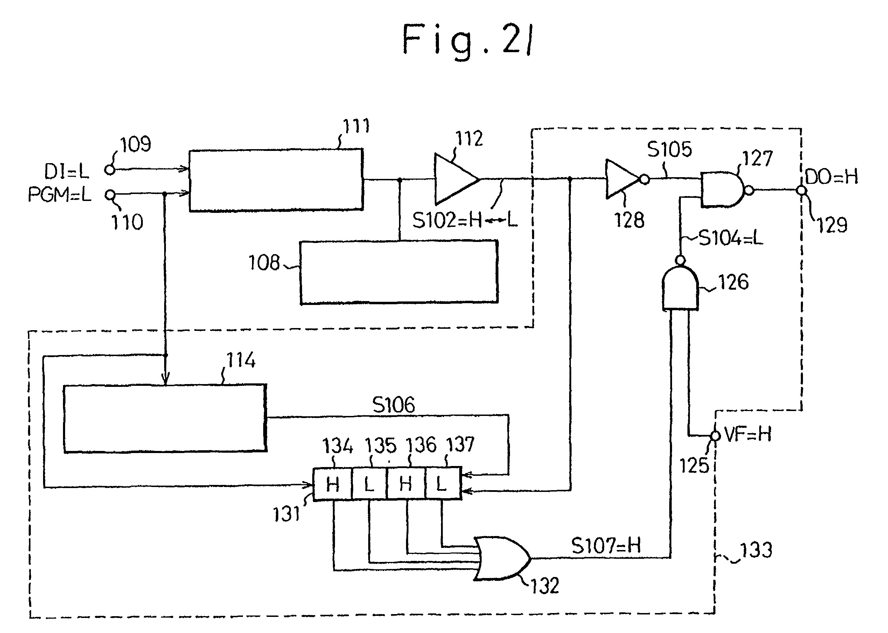

Contrary to this, in the case where the output S102 of the sense amplifier is "H" stably after the writing operation to the cell transistor, i.e. the writing operation to the cell transistor is not completed properly, as shown in Figs. 16 and 20, the level read by the shift register 131 at each pulse in the timing signal S106 is always "H". Thereupon, the stored contents of the respective bits 134, 135, 136, 137 of the shift register 131 become "H", "H", "H", "H", and an output S107 of the OR circuit 132 becomes "H".

When the verify signal VF becomes "H" in this state, the output S104 of the NAND circuit 126 becomes "L" and the output of the NAND circuit 127, namely the output data DO, becomes "H" which is fed to the EPROM writer.

In this case, the write data DI is "L" and the output data DO is "H", and the write data DI is at variance with the output data DO. Accordingly, the EPROM writer returns to Step (2) assuming that the writing operation to the cell transistor is insufficient, and carries out the writing operation on this cell transistor again.

Further, in the case where the sense amplifier 112 oscillates such that the output S102 thereof oscillates after the writing operation on the cell transistor as shown in Figs. 17 and 21, the levels read by the shift register 131 become, for example, "H", "L", "H", "L". Thereupon, the stored contents of the respective bits 134, 135, 136, 137 of the shift register 131 become "H", "L", "H", "L", and an output S107 of the OR circuit 132 becomes "H".

When the verify signal VF becomes "H" in this state, the output S104 of the NAND circuit 126 becomes "L" and the output of the NAND circuit 127, namely the output data DO, becomes "H" which is fed to the EPROM writer.

In this case as well, the write data DI is "L" and the output data DO is "H", and the write data DI is at variance with the output data DO. Accordingly, the EPROM writer carries out the writing operation on this cell transistor again assuming that so far the writing operation for the cell transistor has been insufficient.

In this way, in the second embodiment as well, the write verifying circuit 133 outputs "L" (signifying that the write data coincides with (has the same level as) the output data DO) only in the case where the sense amplifier 112 outputs "L" stably after the writing operation to the cell transistor, i.e. the writing operation to the cell transistor is sufficient to prevent the sense amplifier 112 from oscillating.

On the contrary, the write verifying circuit 133 outputs "H" (signifying that the write data DI does not coincide with (has a level different from) the output data DO) in the case where the sense amplifier 112 outputs "H" stably or oscillates after the writing operation on the cell transistor, i.e. the writing operation on the cell transistor is not sufficient to prevent the sense amplifier 112 from oscillating.

In this way, just as in the first embodiment, it can be verified through the built-in write verifying circuit 133 whether the writing operation on the cell transistor is sufficient to the degree that the sense amplifier 112 does not oscillate during the reading operation. Thus, when the information is written in the cell transistor, the writing operation can be executed to a sufficient extent that the sense amplifier 112 does not oscillate during the reading operation.

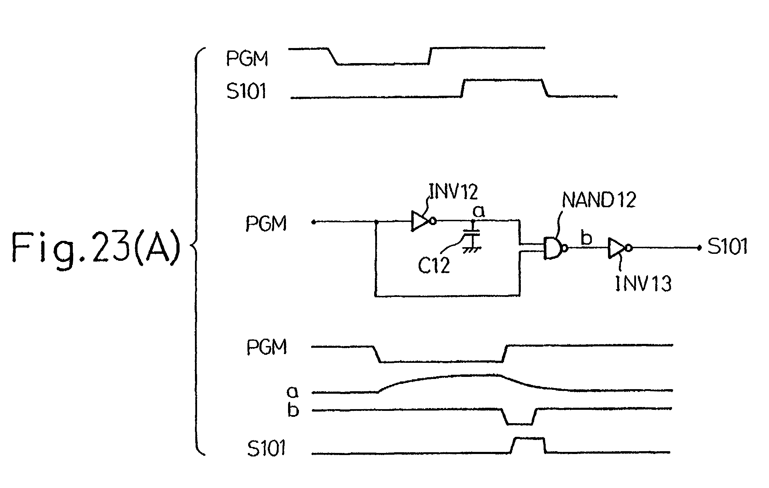

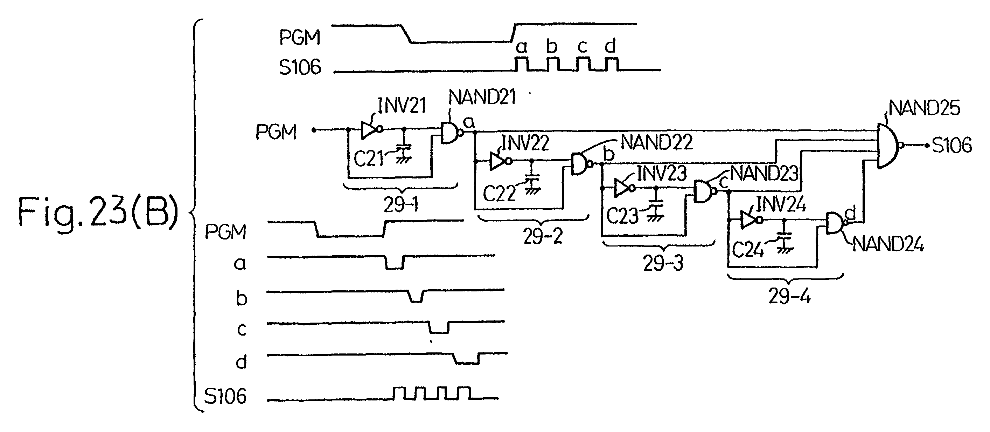

Next will be described examples of the construction of the timing signal generating circuit 114 used in the above first and second embodiments with reference to Figs. 23(A) and 23(B).

Fig. 23(A) shows an example of a construction of the timing signal generating circuit 114 used in the first embodiment of the present invention shown in Fig. 6. This circuit 114 is constructed as follows. An inverter INV12 has an input terminal to which the program signal PGM is input and an output terminal connected to one end of a capacitor C12. The other end of the capacitor C12 is grounded. The output terminal of the inverter INV12 is connected to one input terminal of a NAND circuit NAND12. To the other input terminal of the NAND circuit NAND12 is input the program signal PGM.

Further, the output terminal of the NAND circuit NAND12 is connected to an input terminal of another inverter INV13, the output of which is the output of the timing signal generating circuit 114.

In the timing signal generating circuit 114 thus constructed, when the program signal PGM input to the input terminal of the inverter INV12 has the "L" level, the potential at a point $\underline{a}$ increases gradually due to the presence of the capacitor. When this potential becomes in excess of a specified voltage level, a signal of "H" level is input to the NAND circuit NAND12. Thereafter, when the level of the program signal PGM changes to "H", the potential at a point $\underline{b}$ which is the output of the NAND circuit NAND12 becomes "L" level and the output of the inverter INV13, namely the output S101, becomes "H" level after lapse of a specified delay period.

Thereafter, when the capacitor is discharged, thereby reducing the potential at the point $\underline{a}$ lower than the specified level, the output of the NAND circuit NAND12 is inverted to "H" level. Thus, the output of the inverter INV13, namely the output S101, is also inverted to "L" level.

Fig. 23(B) shows an example of a construction of the timing signal generating circuit 114 used in the second embodiment of the present invention shown in Fig. 14. This circuit 114 is provided with a first circuit 29-1, a second circuit 29-2, a third circuit 29-3, and a fourth circuit 29-4. The first circuit 29-1 is constructed as follows. An inverter INV21 has an input terminal to which the program signal PGM is input and an output terminal connected to one end of a capacitor C21. The other end of capacitor C21 is grounded. The output terminal of the inverter INV21 is connected to one input terminal of a NAND circuit NAND21. To the other input terminal of the NAND, circuit NAND21 is input the program signal PGM. The second circuit 29-2 is constructed as follows. An inverter INV22 has an input terminal to which the output of the first circuit 29-1 is input and an output terminal connected to one end of a capacitor C22. The other end of the capacitor C22 is grounded. The output terminal of the inverter INV22 is connected to one input terminal of a NAND circuit NAND22. To the other input terminal of the NAND circuit NAND22 is input the output of the first circuit 29-1.

Further, the third circuit 29-3 is constructed as follows. An inverter INV23 has an input terminal to which the output of the second circuit 29-2 is input and an output terminal connected to one end of a capacitor C23. The other end of the capacitor C23 is grounded. The output terminal of the inverter INV23 is connected to one input terminal of a NAND circuit NAND23. To the other input terminal of the NAND circuit NAND23 is input the output of the second circuit 29-2. The fourth circuit 29-4 is constructed as follows. An inverter INV24 has an input terminal to which the output of the third circuit 29-3 is input and an output terminal connected to one end of a capacitor C24. The other end of the capacitor C24 is grounded. The output terminal of the inverter INV24 is connected to one input terminal of a NAND circuit NAND24. To the other input terminal of the NAND circuit NAND24 is input the output of the third circuit 29-3.

The outputs of the respective circuits 29-1 to 29-4 are connected to input terminals of a NAND circuit NAND25, the output of which is the output S106 of the timing signal generating circuit 114.

In this construction, the change in the potential at a point $\underline{a}$ (which is the output of the first circuit 29-1) when the program signal PGM is input to the input terminal of the timing signal generating circuit 114 is the same as the change in the potential at the point $\underline{b}$ in Fig. 23 (A). Further, since each of the second to fourth circuits 29-2 to 29-4 receives the output of the immediately-preceding circuit, the respective changes in the potential at points b, c, d, (which are the outputs of the second to fourth circuits) are the same as the change in the potential at the point b in Fig. 23(A).

Since the outputs of the signal at the respective points b, c, d change after a specific delay period, four pulse signals can be obtained at the specified intervals as shown in Fig. 23(B).

**Claims**

1. A nonvolatile semiconductor memory including:

a matrix (1) of nonvolatile erasable memory cell transistors (Mij; 108) formed at intersections between word lines (WL1 to WLM) and bit lines (BL11 to BL1K,..., BLn1 to BLnk);
a row decoder (3);
a column decoder (5);
sense amplifiers (71 to 7n; 112) connected operatively to the said bit lines; and
verify means (113; 133) operable to perform at least one type of verify operation, which verify operation may be a write verify operation, carried out on one of the memory cell transistors after that transistor has had information written therein in a write operation performed by write means (111) of the memory, for determining whether or not the said information can be read out accurately from the transistor in a subsequent read operation, or which verify operation may be an erase verify operation, carried out on one of the memory cell transistors after that transistor has had any information written therein erased in an erase operation performed by erase means of the memory, for determining whether or not that information has been erased sufficiently that in a subsequent read operation the transistor is read as being in an erased condition;

**characterised in that** the said verify means include:

storage means (131) operable, during a predetermined detection period commencing following the said write operation or the said erase operation, as the case may be, to store two or more output signals (S102) of that one of the said sense amplifiers (112) which is connected to the said one memory cell transistor involved in the write or erase operation concerned, each said output signal representing a result of a comparison between a read signal derived from the transistor and a reference signal;
decision means (126-128) operable to detect when the result represented by any one of the stored output signals is not a predetermined desired result for the said write or erase operation concerned and, following such detection, to determine that the write or erase operation was not sufficient that in said subsequent read operation the correct information will be read out even when a power source voltage applied to the memory exhibits variation; and
repeat means (130) operable, when the determination by the said decision means is that the said write operation or erase operation was not sufficient, to cause that operation be repeated.

2. A nonvolatile semiconductor memory as claimed in claim 1, further comprising:

timing signal generation means (114) for generating a series of timing pulses (S106) over the course of the. said predetermined detection period;
the said storage means (131) being operable in response to each timing pulse of the said series to store the sense-amplifier output signal (S102) at the time of the timing pulse concerned; and
the said decision means (126 to 128) being operable, after such sense-amplifier output signals (S102) have been stored in response to all of the pulses of the said series, to detect when the result represented by any one of the stored output signals is not said predetermined desired result.

3. A nonvolatile semiconductor memory as claimed in claim 2, wherein the said storage means (131) comprise a shift register (131) having:

a data input connected for receiving the said sense-amplifier output signal (S102);
a shift input connected for receiving the timing pulses of the said series;
a plurality of storage portions, each for storing one of the said output signals (S102); and
a plurality of data outputs corresponding respectively to the said storage portions of the said plurality, each for outputting the stored output signal held in its corresponding storage portion;
the said decision means (126 to 128) being connected to the said data outputs for detecting when the result represented by the stored output signal at any one of the said data outputs is not the said predetermined desired result.

4. A nonvolatile semiconductor memory including:

a matrix (1) of nonvolatile erasable memory cell transistors (Mij; 108) formed at intersections between word lines (WL1 to WLM) and bit lines (BL11 to BL1K,..., BLn1 to BLnk);

a row decoder (3);

a column decoder (5);

sense amplifiers (71 to 7n; 112) connected operatively to the said bit lines; and

verify means (113; 133) operable to perform at least one type of verify operation, which verify operation may be a write verify operation, carried out on one of the memory cell transistors after that transistor has had information written therein in a write operation performed by write means (111) of the memory, for determining whether or not the said information can be read out accurately from the transistor in a subsequent read operation, or which verify operation may be an erase verify operation, carried out on one of the memory cell transistors after that transistor has had any information written therein erased in an erase operation performed by erase means of the memory, for determining whether or not that information has been erased sufficiently that in a subsequent read operation the transistor is read as being in an erased condition;

**characterised in that** the said verify means include:

decision means (115, 126-128) operable, during a predetermined detection period commencing following the said write operation or the said erase operation, as the case may be, to detect a preselected transition in an output signal (S102) of that one of the said sense amplifiers (112) which is connected to the said one memory cell transistor involved in the write or erase operation concerned, the said output signal representing a result of a comparison between a read signal derived from the transistor and a reference signal, and, following such detection, to determine that the write or erase operation was not sufficient that in said subsequent read operation the correct information will be read out even when a power source voltage applied to the memory exhibits variation; and

repeat means (130) operable, when the determination by the said decision means is that the said write operation or erase operation was not sufficient, to cause that operation be repeated.

5. A nonvolatile semiconductor memory as claimed in claim 4, wherein the said decision means (115, 126-128) comprise a flip-flop (115) which is connected for receiving the sense-amplifier output signal (S102) continuously during the said predetermined detection period ($T_3$ to $T_4$) and which is

switched from a first state (L) to a second state (H) in the event that said preselected transition in the sense-amplifier output signal (S102) occurs.

6. A nonvolatile semiconductor memory as claimed in claim 1, 4 or 5, further comprising:

timing signal generation means (114) for generating a timing signal (S101) defining the said predetermined detection period ($T_3$ to $T_4$).

**Patentansprüche**

1. Nichtflüchtiger Halbleiterspeicher, enthaltend:

eine Matrix (1) nichtflüchtiger löschbarer Speicherzellentransistoren (Mij; 108), die an Schnittpunkten zwischen Wortleitungen (WL1 bis WLM) und Bitleitungen (BL11 bis BL1K,... BLn1 bis BLnk) gebildet sind;

einen Reihendecodierer (3);

einen Spaltendecodierer (5);

Leseverstärker (71 bis 7n; 112), die betriebsfähig mit den Bitleitungen verbunden sind; und

Verifiziermittel (113; 133), die betreibbar sind, um zumindest eine Art einer Verifizieroperation durchzuführen, welche Verifizieroperation eine Schreib-Verifizieroperation sein kann, die an einem der Speicherzellentransistoren ausgeführt wird, nachdem dieser Transistor in einer von einem Schreibmittel (111) des Speichers durchgeführten Schreiboperation eine Information darin schreiben ließ, um zu bestimmen, ob die Information aus dem Transistor in einer nachfolgenden Leseoperation genau ausgelesen werden kann oder nicht, oder welche Verifizieroperation eine Lösch-Verifizieroperation sein kann, die an einem der Speicherzellentransistoren ausgeführt wird, nachdem der Transistor in einer von einem Löschmittel des Speichers durchgeführten Löschoperation eine beliebige darin geschriebene Information löschen ließ, um zu bestimmen, ob die Information ausreichend gelöscht worden ist oder nicht, damit in einer nachfolgenden Leseoperation der Transistor als in einem gelöschten zustand seiend gelesen wird;

**dadurch gekennzeichnet, daß** die Verifiziermittel enthalten:

Speichermittel (131), die betreibbar sind, um während einer vorbestimmten Detektionsperiode, die je nachdem nach der Schreiboperation oder der Löschoperation beginnt, um zwei oder mehr Ausgangssignale (S102) des einen der Leseverstärker (112) zu speichern, der mit dem einen Speicherzellentransistor verbunden ist, der an der betreffenden Schreib- oder Löschoperation beteiligt ist, wobei jedes Ausgangssignal ein Ergebnis eines Vergleichs zwischen einem vom Transistor abgeleiteten Lesesignal und einem Referenzsignal repräsentiert;

Entscheidungsmittel (126 - 128), die betreibbar sind, um zu detektieren, wenn das durch eines der gespeicherten Ausgangssignale repräsentierte Ergebnis kein vorbestimmtes gewünschtes Ergebnis für die betreffende Schreib- oder Löschoperation ist, und um nach einer solchen Detektion zu bestimmen, daß die Schreib- oder Löschoperation nicht ausreichte, damit in der nachfolgenden Leseoperation die korrekte Information ausgelesen wird, selbst wenn eine an den Speicher angelegte Stromversorgungsspannung eine Schwankung zeigt; und

Wiederholmittel (130), die betreibbar sind, um zu veranlassen, daß diese Operation wiederholt wird, wenn die Bestimmung durch die Detektionsmittel darin besteht, daß die Schreiboperation oder Löschoperation nicht ausreichte.

2. Nichtflüchtiger Halbleiterspeicher nach Anspruch 1, ferner aufweisend:

ein Zeitsteuersignal-Erzeugungsmittel (114) zum Erzeugen einer Reihe von Zeitsteuerpulsen (S106) während des Verlaufs der vorbestimmten Detektionsperiode;

wobei die Speichermittel (131) als Antwort auf jeden Zeitsteuerpuls der Reihe betreibbar sind, um das Leseverstärker-Ausgangssignal (S102) zur Zeit des betreffenden Zeitsteuerpulses zu speichern; und

die Entscheidungsmittel (126 bis 128) betreibbar sind, nachdem solche Leseverstärker-Ausgangssignale (S102) als Antwort auf alle Pulse der Reihe gespeichert worden sind, um zu detektieren, wenn das durch das eine der gespeicherten Ausgangssignale repräsentierte Ergebnis nicht das vorbestimmte gewünschte Ergebnis ist.

3. Nichtflüchtiger Halbleiterspeicher nach Anspruch 2, worin die Speichermittel (131) ein Schieberegister (131) aufweisen mit:

einem Dateneingang, der zum Empfangen des Leseverstärker-Ausgangssignals (S102) angeschlossen ist;

einem Verschiebungseingang, der zum Empfangen der Zeitsteuerpulse der Reihe angeschlossen ist;

mehreren Speicherabschnitten, jeder zum Speichern eines der Ausgangssignale (S102); und

mehreren jeweils den Speicherabschnitten der Mehrzahl entsprechenden Datenausgängen, jeder zum Abgeben des in seinem entsprechenden Speicherabschnitt gehaltenen gespeicherten Ausgangssignals;

welche Entscheidungsmittel (126 bis 128) mit den Datenausgängen verbunden sind, um zu detektieren, wenn das durch das gespeicherte Ausgangssignal an einem der Datenausgänge repräsentierte Ergebnis nicht das vorbestimmte gewünschte Ergebnis ist.

4. Nichtflüchtiger Halbleiterspeicher, enthaltend:

eine Matrix (1) nichtflüchtiger löschbarer Speicherquellentransistoren (Mij; 108), die an Schnittpunkten zwischen Wortleitungen (WL1 bis WLM) und Bitleitungen (BL11 bis B11k,..., BLn1 bis BLnk) geschaffen sind;

einen Reihendecodierer (3);

einen Spaltendecodierer (5);

Leseverstärker (71 bis 7n; 112), die betriebsfähig mit dem Bitleitungen verbunden sind; und

Verifiziermittel (113; 133), die betreibbar sind, um zumindest eine Art einer Verifizieroperation durchzuführen, welche Verifizieroperation eine Schreib-Verifizieroperation sein kann, die an einem der Speicherzellentransistoren ausgeführt wird, nachdem der Transistor in einer von einem Schreibmittel (111) des Speichers durchgeführten Schreiboperation eine Information darin schreiben ließ, um zu bestimmen, ob die Information aus dem Transistor in einer nachfolgenden Leseoperation genau ausgelesen werden kann oder nicht, oder welche Verifizieroperation eine Lösch-veriifizieroperation sein kann, die an einem der Speicherzellentransistoren ausgeführt wird, nachdem der Transistor in einer von einem Löschmittel des Speichers durchgeführten Löschoperation eine beliebige darin geschriebene Information löschen ließ, um zu bestimmen, ob die Information ausreichend gelöscht worden ist oder nicht, damit in einer nachfolgenden Leseoperation der Transistor als in einem gelöschten Zustand seiend gelesen wird;

**dadurch gekennzeichnet, daß** Verifiziermittel enthalten:

Entscheidungsmittel (115, 126 - 128), die betreibbar sind, um während einer vorbestimmten Detektionsperiode, die je nachdem nach der Schreiboperation oder der Löschoperation beginnt, einen vorher ausgewählten Übergang in einem Ausgangssignal (S102) des einen der Leseverstärker (112) zu detektieren, der mit dem einen an der betreffenden Schreib- oder Löschoperation beteiligten Speicherzellentransistor verbunden ist, welches Ausgangssignal ein Ergebnis eines Vergleichs zwischen einem vom Transistor abgeleiteten Lesesignal und einem Referenzsignal repräsentiert, und um nach einer solchen Detektion zu bestimmen, daß die Schreib- oder Löschoperation nicht ausreichte, damit in der nachfolgenden Leseoperation die korrekte Information ausgelesen wird, selbst wenn eine an den Speicher angelegte Stromversorgungsspannung eine Schwankung zeigt; und

Wiederholmittel (130), die betreibbar sind, um zu veranlassen, daß die Operation wiederholt wird, wenn die Bestimmung durch die Entscheidungsmittel darin besteht, daß die Schreiboperation oder Löschoperation nicht ausreichte.

5. Nichtflüchtiger Halbleiterspeicher nach Anspruch 4, worin die Entscheidungsmittel (115, 126-128) ein Flipflop (115) aufweisen, das angeschlossen ist, um das Leseverstärker-Ausgangssigna1 (S102) während der vorbestimmten Detektionsperiode ($T_3$ bis $T_4$) kontinuierlich zu empfangen, und das von einem ersten Zustand (L) in einen zweiten Zustand (H) in dem Fall umgeschaltet wird, in dem der vorher ausgewählte Übergang in dem Leseverstärker-Ausgangssignal (S102) stattfindet.

6. Nichtflüchtiger Halbleiterspeicher nach Anspruch 1, 4 oder 5, ferner aufweisend:

Zeitsteuersignal-Erzeugungsmittel (114) zum Erzeugen eines Zeitsteuersignals (S101), das die vorbestimmte Detektionsperiode ($T_3$ bis $T_4$) definiert,

## Revendications

1. Une mémoire à semiconducteur non volatile comprenant :

une matrice (1) de transistors de cellules de mémoire effaçable non volatile (Mij; 108) formés à des intersections entre des conducteurs de mot (WL1 à WLM) et des conducteurs de bit (BL11 à BL1K, ..., BLn1 à BLnk);
un décodeur de ligne (3);
un décodeur de colonne (5);
des amplificateurs de lecture (71 à 7n; 112) connectés fonctionnellement aux conducteurs de bit; et
des moyens de vérification (113; 133) qu'on peut faire fonctionner pour effectuer au moins un type d'opération de vérification, cette opération de vérification pouvant être une opération de vérification d'écriture, accomplie sur l'un des transistors de cellules de mémoire après que de l'information a été écrite dans celui-ci dans une opération d'écriture effectuée par des moyens d'écriture (111) de la mémoire, pour déterminer si cette information peut être lue de manière exacte, ou non, à partir du transistor, dans une opération de lecture ultérieure, ou bien cette opération de vérification pouvant être une opération de vérification d'effacement accomplie sur l'un des transistors de cellules de mémoire après que de l'information écrite dans ce transistor a été effacée dans une opération d'effacement effectuée par des moyens d'effacement de la mémoire, pour déterminer si cette information a été suffisamment effacée pour que dans une opération de lecture suivante le transistor soit lu comme étant dans une condition effacée;

**caractérisée en ce que** les moyens de vérification comprennent:

des moyens d'enregistrement (131) qu'on peut faire fonctionner, pendant une période de détection prédéterminée commençant à la suite de l'opération d'écriture ou de l'opération d'effacement, selon le cas, de façon à enregistrer deux signaux de sortie ou plus (S102) de celui des amplificateurs de lecture (112) qui est connecté au transistor de cellule de mémoire intervenant dans l'opération d'écriture ou d'effacement concernée, chaque signal de sortie représentant un résultat d'une comparaison entre un signal de lecture, obtenu à partir du transistor, et un signal de référence;
des moyens de décision (126-128) qu'on peut faire fonctionner pour détecter la condition dans laquelle le résultat représenté par l'un quelconque des signaux de sortie enregistrés n'est pas un résultat désiré prédéterminé pour l'opération d'écriture ou d'effacement concernée et, à la suite de cette détection, pour déterminer que l'opération d'écriture ou d'effacement n'était pas suffisante pour que dans l'opération de lecture suivante l'information correcte soit lue même lorsqu'une tension de source d'énergie appliquée à la mémoire présente une variation; et
des moyens de répétition (130) qu'on peut faire fonctionner pour provoquer la répétition de cette opération, lorsque les moyens de décision déterminent que l'opération d'écriture ou l'opération d'effacement n'était pas suffisante.

2. Une mémoire à semiconducteur non volatile selon la revendication 1, comprenant en outre :

des moyens de génération de signaux de temps (114) pour générer une série d'impulsions de temps (S106) au cours de la période de détection prédéterminée;

les moyens d'enregistrement (131) pouvant fonctionner en réponse à chaque impulsion de temps de la série de façon à enregistrer le signal de sortie d'amplificateur de lecture (S102) à l'instant de l'impulsion de temps concernée; et

les moyens de décision (126 à 128) pouvant fonctionner, après que de tels signaux de sortie d'amplificateur de lecture (S102) ont été enregistrés en réponse à toutes les impulsions de la série, de façon à détecter la condition dans laquelle le résultat représenté par l'un quelconque dès signaux de sortie enregistrés n'est pas le résultat désiré prédéterminé.

3. Une mémoire à semiconducteur non volatile selon la revendication 2, dans laquelle les moyens d'enregistrement (131) comprennent un registre à décalage (131) ayant :

      une entrée de données connectée pour recevoir le signal de sortie d'amplificateur de lecture (S102);

      une entrée de décalage connectée pour recevoir les impulsions de temps de la série;

      une multiplicité de parties d'enregistrement, chacune étant destinée à enregistrer l'un des signaux de sortie (S102); et

      une multiplicité de sorties de données correspondant respectivement aux parties de stockage de ladite multiplicité, chacune étant destinée à émettre le signal de sortie enregistré qui est conservé dans sa partie d'enregistrement correspondante;

      les moyens de décision (126 à 128) étant connectés aux sorties de données pour détecter la condition dans laquelle le résultat représenté par le signal de sortie enregistré sur l'une quelconque des sorties de données n'est pas le résultat désiré prédéterminé.

4. Une mémoire à semiconducteur non volatile comprenant ;

      une matrice (1) de transistors de cellules de mémoire effaçable non volatile (Mij; 108) formés à des intersections entre des conducteurs de mot (WL1 à WLM) et des conducteurs de bit (BL11 à BL1K, ..., BLn1 à BLnk);

      un décodeur de ligne (3);

      un décodeur de colonne (5);

      des amplificateurs de lecture (71 à 7n; 112) connectés fonctionnellement aux conducteurs de bit; et

des moyens de vérification (113; 133) qu'on peut faire fonctionner pour effectuer au moins un type d'opération de vérification, cette opération de vérification pouvant être une opération de vérification d'écriture, accomplie sur l'un des transistors de cellules de mémoire après que de l'information a été écrite dans celui-ci dans une opération d'écriture effectuée par des moyens d'écriture (111) de la mémoire, pour déterminer si cette information peut être lue de manière exacte, ou non, à partir du transistor, dans une opération de lecture ultérieure, ou bien cette opération de vérification pouvant être une opération de vérification d'effacement accomplie sur l'un des transistors de cellules de mémoire après que de l'information écrite dans ce transistor a été effacée dans une opération d'effacement effectuée par des moyens d'effacement de la mémoire, pour déterminer si cette information a été suffisamment effacée pour que dans une opération de lecture suivante le transistor soit lu comme étant dans une condition effacée;

      **caractérisée en ce que** les moyens de vérification comprennent:

      des moyens de décision (115, 126-128) qu'on peut faire fonctionner, pendant une période de détection prédéterminée commençant à la suite de l'opération de l'écriture ou de l'opération d'effacement, selon le cas, pour détecter une transition présélectionnée dans un signal de sortie (S102) de celui des amplificateurs de lecture (112) qui est connecté au transistor de cellule de mémoire qui intervient dans l'opération d'écriture ou d'effacement concernée, ce signal de sortie représentant un résultat d'une comparaison entre un signal de lecture obtenu à partir du transistor et un signal de référence et, à la suite de cette détection, pour déterminer que l'opération d'écriture ou d'effacement n'était pas suffisante pour que dans l'opération de lecture suivante l'information correcte soit lue même lorsqu'une tension de source d'énergie appliquée à la mémoire présente une variation; et

      des moyens de répétition (130) qu'on peut faire fonctionner pour provoquer la répétition de cette opération, lorsque les moyens de décision déterminent que l'opération d'écriture ou l'opération d'effacement n'était pas suffisante.

5. Une mémoire à semiconducteur non volatile selon la revendication 4, dans laquelle les moyens de décision (115, 126-128) comprennent une bascule (115) qui est connectée pour recevoir continuellement le signal de sortie d'amplificateur de lecture (S102) pendant la période de détection prédéterminée ($T_3$ à $T_4$), et qui est commutée d'un premier état (L) à un second état (H) dans le cas où la transition présélectionnée du signal de sortie d'amplificateur de lecture (S102) se produit.

6. Une mémoire à semiconducteur non volatile selon la revendication 1, 4 ou 5, comprenant en outre :

   des moyens de génération de signal de temps (114) pour générer un signal de temps (S101) définissant la période de détection prédéterminée ($T_3$ à T4).

# Fig.1

EP 0 884 734 B1

# Fig. 2

# Fig. 3

# Fig. 4

# Fig. 5

CURRENT FLOWN THROUGH CELL TRANSISTOR

DESCRIMINATING LEVEL FOR SENSE AMPLIFIER

REPETITION NUMBER FOR WRITING

Fig. 6

Fig. 7

Fig. 8

Fig. 9

# Fig. 10

# Fig. 11

EP 0 884 734 B1

Fig.12

# Fig. 13

EP 0 884 734 B1

# Fig.14

EP 0 884 734 B1

Fig.15

Fig.16

Fig.17

Fig. 18

DO 129
127
S104 126
S105
128
S102
112
111
108
114
VF=L 125
133
S107
132
S106
134 135 136 137
131
DI=L 109
PGM=H 110
L L L L

Fig.19

# Fig. 20

EP 0 884 734 B1

# Fig. 21

# Fig.22(A)

START

CELL SELECTION ADDRESS
X IS SELECTED (1)

WRITING IN THE SELECTED
CELL (PGM) (2)

IS PREDETERMINED
PERIOD PASSED?
? (3)

NO

YES

INPUT VERIFY SIGNAL (4)

IS OUTPUT OF
WRITING OPERATION DETECTING
CIRCUIT "H"?
? (5)

YES

NO

ADDRESS SELECTION
X ← X + 1 (6)

IS "X" END
? (7)

NO

YES

END

# Fig.22(B)

START

CELL SELECTION ADDRESS
X IS SELECTED (1)

WRITING IN THE SELECTED
CELL (PGM) (2)

IS PREDETERMINED
PERIOD PASSED?
? (3)

NO

YES

N PULSES ARE GENERATED (31)

OUT PUT OF SENSE-AMPLIFIER
IS STORED
AT EVERY TIME WHEN THE PULSE
IS GENERATED (32)

INPUT VERIFY SIGNAL (4)

IS OUTPUT OF
WRITING OPERATION DETECTING
CIRCUIT "H"?
? (5)

YES

NO

ADDRESS SELECTION
X ← X + 1 (6)

IS "X" END
? (7)

NO

YES

END

EP 0 884 734 B1

# Fig.23(A)

Fig.23(B)